# DEMANDE DE BREVET EUROPEEN

(11) **EP 4 697 223 A1**
(43) Date de publication de la demande: **18.02.2026**
(21) Numéro de dépôt: 25194197.7
(22) Date de dépôt: 05.08.2025
(51) Int. Cl.: G06F 30/10, G06F 30/27, G06N 5/022, G06Q 10/101, G06N 20/00, G06Q 10/20, G06Q 50/04

(54) **PROCÉDÉ ET SYSTÈME DE GÉNÉRATION DE SOLUTION TECHNIQUE NOUVELLE**

(30) Priorité: 16.08.2024 FR 2408942
(71) Demandeur: Airbus SAS, 31700 Blagnac Cedex (FR)
(72) Inventeur: ROUYRE, François Gabriel Yves, 31700 Blagnac Cedex (FR)
(74) Mandataire: BCF Global

(57) **Abrégé**

L'invention porte sur un procédé et système de génération de solution technique nouvelle, comprenant d'acquérir des données d'un PLM de produit industriel comportant au moins deux objets 3D, d'extraire des données de PLM des Attributs et Règles pour chaque objet 3D, de générer un graphe de connaissances de Relations arborescentes entre les objets 3D, de générer des Attributs de topologie pour chaque objet 3D, de regrouper pour chaque objet 3D, ses Attributs et Règles, ses Relations arborescentes et ses Attributs de topologie dans au moins une base de données relationnelle, sous forme de voxel, de recevoir une requête d'un Utilisateur (102) relative à une solution technique, la requête comprenant au moins un volume 3D, d'évaluer si la solution technique est présente dans le PLM, et si elle n'est pas présente: de générer une solution technique nouvelle dans le volume 3D, mettant en oeuvre au moins un nouvel objet 3D, générer un nouveau voxel associé au nouvel objet 3D, et réinjecter le nouveau voxel dans la base de données relationnelle.

## Description

### Domaine

La présente invention concerne un procédé et système de génération de solution technique nouvelle, et plus particulièrement un procédé et système de proposition de solution technique mettant en oeuvre un nouvel objet 3D généré à partir de données PLM de pièces élémentaires existantes, regroupées sous forme de voxel.

### Contexte

La gestion du cycle de vie d'un produit industriel tel un aéronef, une automobile, un train, etc, encore appelé PLM (pour « Product Lifecycle Management », en Anglais), est un processus interne à l'entreprise de gestion du parcours complet d'un produit industriel depuis sa conceptualisation, son développement, sa mise en service et jusqu'à sa mise au rebut. C'est la gestion de tout ce qui est lié au produit, du début jusqu'à sa fin de vie.
Dans ce contexte, la Maquette numérique 3D (« 3D Digital Mock-up », DMU, en Anglais) est par ailleurs un support obligatoire pour faire face à la compétitivité, à la qualité des produits industriels et à la sécurité. Son efficacité est démontrée dans la manière d'accompagner la définition, la fabrication, la maintenance et l'exploitation desdits produits industriels. Elle est généralement générée par un logiciel de Conception Assistée par Ordinateur, CAO (« Computer Aided Design, CAD, en Anglais). Elle est utile à l'ensemble des départements d'une entreprise impliqués dans la conception, la fabrication, la maintenance et l'exploitation des produits industriels, mais ne peut généralement pas être utilisée telle quelle, tous les départements n'étant pas nécessairement équipés des mêmes outils et/ou de la même puissance informatique que le département qui a produit une Maquette numérique 3D donnée. Typiquement, ils n'utilisent pas tous le même logiciel de CAO.
Chaque département génère et manipule une grande quantité de données, et le plus souvent, ces données sont en silos, dans un format et une optimisation pour la performance de traitement qui n'est pas standardisée entre départements. Ainsi l'utilisation de données produites par d'autres départements, si nécessaire, requiert une adaptation et une intervention manuelle, et il n'existe pas de service transversal, ou de forme « allégée et/ou simplifiée » (ie moins gourmande en ressources informatiques) de la Maquette numérique 3D, pour faciliter dans les opérations les activités des utilisateurs autour du produit industriel, et notamment récupérer le dossier de définition 3D pour les besoins personnalisés de ces autres départements.
De plus, il est difficile d'identifier la fonction d'un objet 3D faisant partie de la composition d'un produit industriel, sur la base uniquement des formes ou dimensions de l'objet, dans la mesure où son identification dans les différentes Maquettes numériques 3D met en jeu des paramètres ou des caractéristiques techniques qui ne sont pas les mêmes d'une Maquette numérique 3D à l'autre.
Les commentaires ci-dessus s'appliquent en tout ou partie au cas de pièces élémentaires qui ne sont pas des objets 3D issus de Maquette numérique, mais des pièces standard du marché qui font aussi partie du PLM, avec des données de PLM correspondantes.

De nouveaux développements sont donc nécessaires, afin de relier toutes les bases de données existantes au sein de l'entreprise, incluant la représentation d'objets 3D, dans un vaste réseau construit d'interdépendances, d'informations et de caractéristiques sur chaque pièce élémentaire composant un produit industriel, gérée ou devant être gérée dans n'importe quel département de l'entreprise, de bout en bout du cycle de vie (définition, fabrication, maintenance, exploitation, mise au rebut, recyclage) du produit industriel. Ces développements doivent être mis en œuvre pour gérer n'importe quel environnement informatique, en utilisant des objets 3D de CAO et des métadonnées dans des bases de données pour les relier dans un réseau organisé et intelligent capable de passer d'un environnement 3D à un autre, mais aussi, sans remettre en cause la gestion du cycle de vie existante du produit industriel, pour permettre de retrouver toutes les information relatives à une pièce élémentaire, et même concevoir de nouvelles solutions techniques de dessin (« design solution » en Anglais) de portions du produit industriel.

Les techniques évoquées dans cette section ne doivent pas être présumées appartenir à l'état de la technique du seul fait de leur seule évocation. De même, un problème mentionné dans cette même section ne doit pas être présumé avoir été précédemment identifié dans l'état de la technique à raison de sa seule mention.

### Résumé

Des modes de réalisation de la présente invention ont été développés sur la base de la compréhension par les développeurs des lacunes associées à l'art antérieur. L'invention propose d'une manière générale, un procédé et système permettant d'utiliser la ou les Maquettes numériques 3D de tout type (outillage, usines, en exploitation, etc.) d'un produit industriel, à tout niveau de granularité dans la décomposition arborescente, PBS (pour « Product Breakdown Structure » en Anglais) des pièces élémentaires composant le produit industriel, et dans des contextes :
- répondant au concept de « jumeau numérique » (ie : une réplique digitale exacte du produit industriel, en permanence mise à jour tout au long du cycle de vie du produit industriel, et qui sert de contrepartie numérique effectivement indiscernable à des fins pratiques, telles que la simulation, l'intégration, les essais, la surveillance et la maintenance);
- à la distribution allégée 3D (démocratisation de l'accès à la 3D sans ordinateur/logiciel CAO); et
- aux activités de gestion du produit industriel à travers la Maquette numérique 3D qui positionne géométriquement chaque pièce élémentaire par rapport aux autres pièces élémentaires composant le produit industriel (facilité de calcul, d'agencement, d'organisation, de compréhension, de génération de modèles).

Plus particulièrement, la présente invention comporte, sous différents modes de réalisation, un procédé de génération de solution technique nouvelle, comprenant les étapes de:
- acquérir des données de PLM d'un produit industriel comportant au moins deux pièces élémentaires, dont l'une au moins est un objet 3D généré par une Maquette numérique 3D ;
- extraire des données de PLM des Attributs et Règles pour chaque pièce élémentaire ;
- générer un graphe de connaissances de Relations arborescentes établissant des relations logiques entre les pièces élémentaires sur le plan géométrique et fonctionnel ;
- générer des Attributs de topologie pour chaque pièce élémentaire ;
- regrouper pour chaque pièce élémentaire, les Attributs et Règles, les Relations arborescentes et les Attributs de topologie dans au moins une base de données relationnelle, sous forme de voxel ;
- recevoir une requête d'un Utilisateur relative à une solution technique, la requête comprenant au moins un volume 3D ;
- évaluer si la solution technique est présente dans le PLM, et si elle n'est pas présente :
- générer et fournir en réponse à la requête de l'Utilisateur, une solution technique nouvelle dans le volume 3D, mettant en oeuvre au moins un nouvel objet 3D ;
- générer un nouveau voxel associé au nouvel objet 3D ; et
- réinjecter le nouveau voxel dans la base de données relationnelle.

Dans un mode de réalisation du procédé, l'étape de regrouper comprend l'étape de sélectionner pour chaque pièce élémentaire certains des Attributs et Règles en fonction des Attributs de topologie.

Dans un autre mode de réalisation, le procédé comprend en outre une étape de correction par l'Utilisateur dans le nouveau voxel, de tout ou partie des Attributs et Règles, Relations arborescentes, et Attributs de topologies, préalablement à l'étape de réinjecter le nouveau voxel dans la base de données relationnelle.

Dans un mode de réalisation du procédé, le graphe de connaissances généré de Relations arborescentes entre les pièces élémentaires, comprend :
- des premières relations logiques entre les pièces élémentaires de position et d'orientation géométrique entre les pièces élémentaires ; et
- des secondes relations logiques entre les pièces élémentaires sur la base de tout ou partie des Attributs et Règles, choisie par l'Utilisateur.

La présente invention comporte également un support lisible par ordinateur, comportant des instructions qui lorsqu'elles sont exécutées, conduisent l'ordinateur à réaliser le procédé ci-dessus.

La présente invention comporte également un système de génération de solution technique nouvelle, comprenant :
- un Extracteur d'Attributs et Règles configuré pour recevoir des données de PLM d'un produit industriel, et extraire, trier et organiser, des Attributs et Règles associés à chacune de pièces élémentaires composant le produit industriel ;
- un Générateur de graphe de connaissances et de relations configuré pour transformer et structurer une décomposition arborescente d'un PBS du produit industriel faisant partie du PLM, en un graphe de connaissances de Relations arborescentes établissant des relations logiques entre les pièces élémentaires sur le plan géométrique et fonctionnel;
- un Générateur topologique 3D et analyseur de similitudes 3D configuré pour générer des Attributs de topologie associés à chacune de pièces élémentaires ;
- un Système d'apprentissage machine 3D et un Générateur de voxels et objets 3D configurés pour:
- regrouper dans une ou plusieurs bases de données relationnelle sous forme de voxel par pièce élémentaire, le voxel comprenant les Attributs et Règles extraits, les Relations arborescentes transformées, et les Attributs de topologie générés ;
- recevoir une requête d'un Utilisateur relative à une solution technique, la requête comprenant au moins un volume 3D ;
- évaluer si la solution technique est présente dans le PLM, et si elle n'est pas présente :
- générer et fournir en réponse à la requête de l'Utilisateur, une solution technique nouvelle dans le volume 3D, mettant en oeuvre au moins un nouvel objet 3D ;
- générer un nouveau voxel associé au nouvel objet 3D ; et
- réinjecter le nouveau voxel dans la base de données relationnelle.

Dans un mode de réalisation du système, le Générateur de voxels et objets 3D est en outre configuré pour recevoir une correction par l'Utilisateur dans le nouveau voxel, de tout ou partie des Attributs et Règles, Relations arborescentes, et Attributs de topologies, préalablement à l'étape de réinjecter le nouveau voxel dans la base de données relationnelle.

Dans un autre mode de réalisation du système, le graphe de connaissances généré de Relations arborescentes entre les pièces élémentaires, comprend :
- des premières relations logiques entre les pièces élémentaires de position et d'orientation géométrique entre les pièces élémentaires ; et
- des secondes relations logiques entre les pièces élémentaires sur la base de tout ou partie des Attributs et Règles, choisie par l'Utilisateur.

Dans le cadre de la présente description, sauf disposition expresse contraire, un « processeur » peut faire référence, mais sans s'y limiter, à tout type de « système informatique », « dispositif électronique », « système informatisé », « unité de contrôle », « dispositif de surveillance », « serveur » et/ou toutes combinaisons de ceux-ci appropriées à la tâche concernée, en relation avec la réception, le stockage, le traitement et/ou la transmission de données.

Dans le cadre de la présente description, l'expression « FPGA » vise à inclure les systèmes de type Field Programmable Gate Array (en Anglais), disponibles sur le marché au moment du dépôt de la présente demande de brevet, tels que les références Xilinx VU9P, ou Intel Stratix V, et toutes les inventions équivalentes ultérieures devenues disponibles, quel que soit leur nom, consistant en un matériel de système informatique programmable avec un logiciel.

Dans le cadre de la présente description, un « processeur » peut comprendre un seul processeur dédié, un seul processeur partagé, ou une pluralité de processeurs individuels, dont certains peuvent être partagés. Un « processeur » peut être un processeur à usage général, tel qu'une unité centrale de traitement (CPU), un processeur dédié à un objectif spécifique ou un processeur implémenté dans un FPGA. D'autres matériels et logiciels, conventionnels et/ou personnalisés, peuvent également être inclus dans un « processeur ».

Dans le cadre de la présente description, un « calculateur » représente indifféremment un ou plusieurs processeurs capables de lire des instructions en vue d'exécuter une fonction, et/ou une fonction réalisée par l'exécution d'instructions par un ou plusieurs processeurs.

Dans le cadre de la présente description, sauf disposition expresse contraire, l'expression "mémoire" inclut les systèmes de stockage à accès aléatoire, disponibles sur le marché au moment du dépôt de la présente demande de brevet, et toutes les inventions équivalentes ultérieures devenant disponibles, quelle que soit leur dénomination, consistant en des supports de systèmes informatiques pour le stockage d'informations numériques. Un exemple d'une telle mémoire peut être une mémoire vive statique (SRAM).

Dans le cadre de la présente description, les étapes fonctionnelles représentées sur les figures peuvent être assurées grâce à l'utilisation de matériel dédié, ainsi que de matériel capable d'exécuter un logiciel approprié.

Dans le cadre de la présente description, sauf disposition expresse contraire, les mots "premier", "deuxième", "troisième", etc. n'ont été utilisés comme adjectifs qu'aux seules fins de permettre de distinguer les noms qu'ils accompagnent les uns des autres, et non dans le but de décrire une relation particulière entre ces noms.

Les mises en œuvre de la présente invention ont chacune au moins un des objets et/ou aspects mentionnés ci-dessus, mais ne les ont pas nécessairement tous.

Des caractéristiques, aspects et avantages supplémentaires et/ou alternatifs des mises en œuvre de la présente invention ressortiront de la description suivante, des dessins joints et des revendications annexées.

### Brève description des dessins

Pour une meilleure compréhension de la présente invention, il est fait référence à la description suivante qui doit être utilisée conjointement avec les dessins ci-joints, où :
[Fig.1] représente une vue schématique d'un système dans un mode de réalisation de l'invention;
[Fig.2] fournit une représentation simplifiée de graphe de connaissances;
[Fig.3] présente des pièces élémentaires d'un assemblage faisant partie d'un produit industriel;
[Fig.4a] représente un premier sous-ensemble de pièces élémentaires;
[Fig.4b] représente un second sous-ensemble de pièces élémentaires, ou solution de dessin;
[Fig.5] fournit une représentation simplifiée du graphe de connaissances généré dans le cas particulier de pièces élémentaires et sous-ensembles montrés aux Fig.3, Fig.4a et Fig.4b;
[Fig.6] fournit une représentation schématique des étapes du procédé selon l'invention; et
[Fig.7] illustre un système informatique qui peut être utilisé pour réaliser les calculateurs visibles sur la Fig.1, ou les étapes de procédé de la Fig.6.

Il convient de noter que, sauf indication contraire explicite, les dessins ne sont pas à l'échelle. Enfin, les éléments identiques d'un dessin à l'autre portent la même référence numérique.

### Description des modes de réalisation

Les exemples et les conditions associées détaillés ici sont principalement destinés à aider le lecteur à comprendre les principes de la présente invention et non à limiter sa portée à ces exemples et conditions spécifiques. On comprendra que l'homme du métier peut concevoir divers agencements qui, bien qu'ils ne soient pas explicitement décrits ou représentés ici, incarnent néanmoins les principes de la présente invention et sont inclus dans son esprit et sa portée.

En outre, pour faciliter la compréhension, la description suivante peut décrire des mises en œuvre relativement simplifiées de la présente invention. Comme l'homme du métier le comprend, d'autres mises en œuvre de la présente invention peuvent être d'une plus grande complexité.

Dans certains cas, des exemples de modifications de la présente invention peuvent également être présentés. Ceci est fait simplement comme une aide à la compréhension, et, à nouveau pas pour définir la portée ou établir les limites de la présente invention. Ces modifications ne sont pas une liste exhaustive, et l'homme du métier pourra apporter d'autres modifications tout en restant dans le cadre de la présente invention.

En outre, toutes les déclarations ci-après relatives aux principes, aspects et mises en œuvre de la présente invention, ainsi que les exemples spécifiques de celle-ci, visent à englober à la fois les équivalents structurels et fonctionnels de celle-ci, qu'ils soient actuellement connus ou développés à l'avenir. Ainsi, par exemple, il sera compris par l'homme du métier que tous les schémas fonctionnels représentent des vues conceptuelles d'exemples de circuits incorporant les principes de la présente invention. De même, il sera bien compris que tous les organigrammes, diagrammes de transition d'état, pseudo-code, et similaires, représentent divers processus qui peuvent être implémentés sur des supports lisibles par ordinateur, et ainsi être exécutés par un ordinateur ou un processeur, qu'un tel l'ordinateur ou processeur soit montré sur les figures ou non.

Les fonctions des divers éléments représentés sur les figures, y compris tout bloc fonctionnel, peuvent être assurées par l'utilisation de matériel dédié ainsi que de matériel capable d'exécuter un logiciel approprié. Elles peuvent également être exécutées par un processeur. D'autres matériels, conventionnels et/ou personnalisés, peuvent également être utilisés.

Les modules logiciels, ou les modules supposés être des logiciels, peuvent être représentés ici comme une combinaison d'éléments d'organigramme, ou d'autres éléments indiquant l'exécution des étapes d'un processus, et/ou comme une description textuelle. De tels modules peuvent être exécutés par un matériel qui est expressément représenté ou pas. De plus, il doit être entendu que « module » peut inclure, par exemple, mais sans s'y limiter, une logique de programme informatique, des instructions de programme informatique, un logiciel, une pile logicielle, un micrologiciel, un circuit matériel, ou une combinaison de ces différents éléments qui fournit les capacités requises.

Ceci étant posé, nous allons maintenant considérer quelques exemples non limitatifs pour illustrer diverses mises en œuvre de la présente invention.

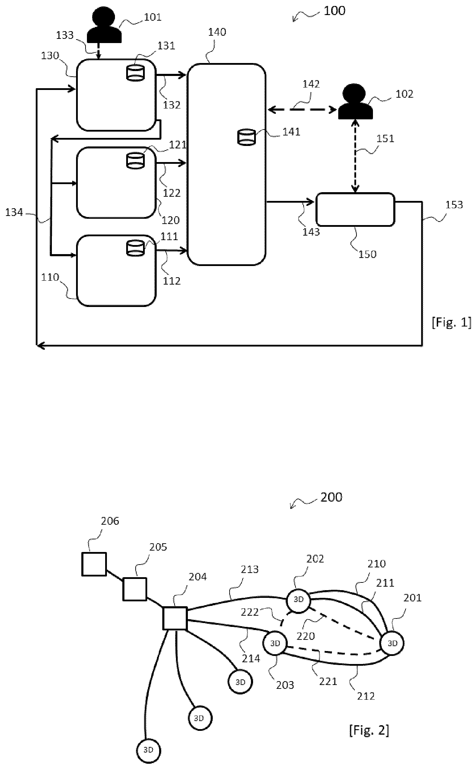

Fig.1 représente une vue schématique d'un Système 100 dans un mode de réalisation de l'invention. Des données composant un PLM pour un produit industriel, appelées données de PLM, sont par exemple fournies (133) par un Administrateur 101. Ces données permettent :
- par l'utilisation qui en est faite par un Extracteur d'Attributs et Règles 130, le tri et l'organisation d'attributs et règles associés à chaque pièce élémentaire composant le produit industriel;
- par l'utilisation qui en est faite par un Générateur de graphe de connaissances et de relations 120, l'exploitation des relations de dépendance dans un PBS; et
- par l'utilisation qui en est faite par un Générateur topologique 3D et analyseur de similitudes 3D 110, le tri et l'organisation d'attributs de topologie d'un objet 3D.

D'autres moyens d'alimenter le Système 100 en données de PLM, notamment à l'initialisation du système, peuvent être conçus et réalisés par l'homme du métier.

Dans ce contexte sont définis:
- des « Attributs », comme des données associées à une pièce élémentaire, désignant une caractéristique propre et distinctive à la pièce élémentaire, par exemple : son matériau, sa masse, sa désignation dans une nomenclature, son numéro de pièce (« Part Number », P/N, en Anglais), son coût, son diamètre, sa longueur, etc.;
- des « Règles », comme des données associées à une pièce élémentaire, en relation avec les méthodes et processus d'utilisation en fonction du métier impliqué dans le cadre du produit industriel (conception, fabrication, maintenance, exploitation, certification, mise au rebut, recyclage, etc.), par exemple : des règles d'assemblage, et plus généralement de relation métier entre une pièce élémentaire et d'autres pièces élémentaires, etc.;
- des « Attributs de topologie », comme des données associées à un objet 3D exprimant des propriétés géométriques invariantes dans la déformation géométrique, par exemple : surface mouillée, volume, longueur, boîte d'encombrement 3D, etc..; et
- des « Relations arborescentes », comme des relations de dépendance d'organisation et de configuration du produit industriel ou d'un sous-ensemble dans le PBS. Ces relations de dépendance peuvent être de différente nature, et être prises individuellement ou combinées, par exemple:
- une relation parent/enfant;
- une relation géométrique de positionnement des pièces élémentaires entre elles (ex : face contre face);
- une relation fonctionnelle de couple galvanique (ex : comparaison d'Attributs de matériau lorsque les pièces élémentaires sont en contact entre elles); etc.

L'Extracteur d'Attributs et Règles 130 utilise, trie et organise les données de PLM relatives à des Attributs et Règles associés à une pièce élémentaire, et les stocke dans un ensemble d'une ou plusieurs bases de données (une seule représentée : 131). Ainsi la base de données 131 contient au moins :
- un ou plusieurs Attributs associés à chaque pièce élémentaire; et
- une ou plusieurs Règles associées à chaque pièce élémentaire.

Le Générateur de graphe de connaissances et de relations 120 transforme et structure en un graphe de connaissances, la décomposition arborescente que constitue le PBS des pièces élémentaires composant le produit industriel donné, et qui peut être représentée comme un arbre avec des noeuds, et des relations structurelles entre les noeuds. Le graphe de connaissances généré établit ainsi une intelligence de proche en proche entre les pièces élémentaires, sur le plan géométrique comme sur le plan fonctionnel :
- par exemple, sur le plan géométrique : en utilisant des matrices de position relative ou absolue, et d'orientation de position, des liens géométriques comme face contre face (avec le cas échéant contact, distance, jeu prédéfini etc.);
- par exemple sur le plan fonctionnel: en utilisant des Règles de métier, physiques et/ou fonctionnelles, propres à chaque produit industriel, par exemple un objet 3D « fixation » liés à d'autres objets 3D attachés ensemble par cette fixation.
La fonction de génération de graphe de connaissances peut être réalisée au travers de logiciels existants et connus de l'homme du métier, par exemple le logiciel Neo4j Graph Database^{™}, mais d'autres solutions sont disponibles pour l'homme du métier. Le graphe de connaissances généré peut être stocké dans un ensemble d'une ou plusieurs bases de données (une seule représentée : 121).

Le Générateur topologique 3D et analyseur de similitudes 3D 110 génère des Attributs de topologie émanant des données de PLM par objet 3D, afin de le rendre unique par lesdits attributs.
Les Attributs de topologie sont générés suivant des critères choisis par l'entreprise et adaptés pour son produit industriel, de caractérisation topologique pour caractériser de manière unique chacune des pièces élémentaires. Le calcul se fait sur la géométrie de la pièce élémentaire par des valeurs numériques et/ou désignation littérale, afin de la classifier, et la raccrocher à son numéro d'identification (ex : numéro de pièce ATA53-N° identification unique), qui fait partie des Attributs.
Le Générateur topologique 3D et analyseur de similitudes 3D 110 caractérise ainsi toutes les pièces élémentaires d'un produit industriel avec des valeurs numériques, et en crée une empreinte digitale (une ou plusieurs valeurs numériques uniques) permettant ensuite de les identifier.
Les Attributs de topologie peuvent être stockés dans un ensemble d'une ou plusieurs bases de données (une seule représentée: 111).

Un Système d'apprentissage machine 3D 140 regroupe dans une ou plusieurs bases de données relationnelles (une seule base de données représentée : 141) sous forme de voxels par pièce élémentaire:
- des Attributs de topologie (111), émanant (112) du Générateur topologique 3D et analyseur de similitudes 3D 110;
- des informations de positionnement relatif (121) par rapport à d'autres pièces élémentaires du produit industriel, émanant (122) du Générateur de graphe de connaissances et de relations 120; et
- des Attributs et Règles de caractérisation des pièces élémentaires (131), émanant (132) de l'Extracteur d'Attributs et Règles 130.
Un voxel de manière connue, stocke une information physique d'un point d'un volume sur un maillage régulier. Il possède ses propres coordonnées de point nodal et d'orientation, dans un système de coordonnées accepté, sa propre forme, son propre paramètre d'état qui indique son appartenance à un objet modélisé, et qui possède des propriétés de la région modélisée.
Dans la présente invention, le voxel, en tant que conteneur, est implémenté comme transportant un ensemble de données relatives à :
- une identité et des caractéristiques géométriques (les coordonnées X,Y,Z, l'orientation L,M,N, une direction, etc.);
- des attributs et autres métadonnées (les Attributs, Attributs de topologie, et Relations arborescentes, comme définis plus haut); et
- des règles associées d'utilisation (les Règles, comme défini plus haut).

Le Système d'apprentissage machine 3D 140 identifie chaque pièce élémentaire venant du Générateur topologique 3D et analyseur de similitudes 3D 110, et le lie au graphe de connaissance généré par le Générateur de graphe de connaissances et de relations 120, et aux Attributs et Règles fournis par l'Extracteur d'Attributs et Règles 130. Les données (112, 122, 132) sont ainsi concaténées en suivant des règles prédéfinies (de géométrie, de liaisons face à face, d'identité d'attributs, etc. propres au mode 3D).
Le Système d'apprentissage machine 3D 140 crée ainsi des modèles statistiques, relationnels et géométriques d'interdépendances logiques entre les différentes pièces élémentaires, au travers de la caractérisation de leurs liaisons dans le graphe de connaissance, enrichies de règles métier, de conception, de calcul, de fabrication, etc...
Le Système d'apprentissage machine 3D 140 peut être également capable de discrétiser tout objet 3D en surfaces élémentaires, sous-objets 3D, afin de pouvoir gérer les objets 3D et créer des bibliothèques 3D.
Les données fournies au Système d'apprentissage machine 3D 140 (112, 122, 132) peuvent être sous forme de tables de données. Ces données permettent de faire les calculs de résultat à fournir à un Utilisateur 102 (qui peut être une seule et même personne avec l'Administrateur 101) en communication (142) avec le Système d'apprentissage machine 3D 140, et des données à fournir (143) à un Générateur de voxels et objets 3D 150.

Le Système d'apprentissage machine 3D 140, sur requête (142) de l'Utilisateur 102, calcule, paramètre et livre (142), une solution technique pour une pièce du produit industriel, consistant en l'assemblage d'une ou plusieurs pièces élémentaires. Le calcul et paramétrage sont effectués sur la base de l'apprentissage par le Système d'apprentissage machine 3D 140, des Attributs, Règles, Relations arborescentes, et Attributs de topologie. Le calcul prend ainsi en compte l'ensemble des données 3D disponibles relatives à un produit industriel déjà réalisé par l'entreprise.
Cette solution technique peut être déjà existante (ie : il y a déjà dans le PLM cette solution technique), ou bien nouvelle, et se baser sur l'ensemble des critères de la demande de l'Utilisateur 102 (incluant tout ou partie de: Attributs et Règles, Relations arborescentes, et Attributs de topologies) afin de proposer une solution technique nouvelle qui soit au plus proche d'une solution technique physiquement réalisable.
Dans ce dernier cas (solution technique nouvelle), le Système d'apprentissage machine 3D 140 fournit à un Générateur de voxels et objets 3D 150, les informations nécessaires à la génération des objets 3D et voxels associés décrivant la solution technique nouvelle.

La requête (142) de l'Utilisateur 102 comprend par exemple un volume dans une zone 3D d'une Maquette numérique 3D, ou une famille topologique d'objets 3D (ex : tous les objets 3D qui ont un volume donné, et/ou une surface mouillée donnée) au travers d'un ou plusieurs Attribut de topologie.

Le Générateur de voxels et objets 3D 150 lie par objet 3D des Attributs de topologie, avec des coordonnées X,Y,Z des centres de gravité des objets 3D, pour générer un ou plusieurs voxels, enrichis d'Attributs et Règles.
Ces objets 3D et voxels associés sont ensuite réinjectés (153) dans l'Extracteur d'Attributs et Règles 130. L'Utilisateur 102 peut, avant réinjection, vérifier (151) les calculs du Générateur de voxels et objets 3D 150, et, le cas échéant, corriger ou enrichir de manière manuelle des objets 3D et voxels associés, et tout ou partie des Attributs et Règles, Relations arborescentes, et Attributs de topologies proposés.
Dans le cas d'une solution technique nouvelle, le Générateur de voxels et objets 3D 150 peut mettre en oeuvre par exemple un logiciel connu Pathfinding Unity^{™}. Avec cette fonction, peut ainsi par exemple être redessinée une pièce dans un volume 3D d'une requête de l'Utilisateur 102, avec sa décomposition en objets 3D et voxels associés, existants ou nouvellement générés.

En Fig.2 est fournie une représentation simplifiée du graphe de connaissances généré par le Générateur de graphe de connaissances et de relations 120. Ce graphe de connaissances est généré à partir de la structure du produit industriel connue dans le PLM, et communiquée au travers du lien 134. La structure du produit industriel a été créée lors de l'activité de dessin : chaque objet 3D composant le produit industriel a en effet été dessiné et positionné dans l'espace digital. Les objets 3D ont des matrices de position entre eux et des orientations, qui sont définies lors de l'activité de dessin avec un logiciel de CAO, font partie des données de PLM, et qui sont enregistrées dans des tables et bases de données 131 de PLM. De plus un code de relation "parent/enfant" (arborescence de la structure de produit) est généré, ce qui permet d'identifier pour chaque modèle son(ses) parent(s) et sa position dans cette structure de produit.

Trois objets 3D 201-203 sont par exemple représentés. Les objets 3D sont définis par les outils de CAO, et, grâce au Générateur topologique 3D et analyseur de similitudes 3D 110, sont caractérisés par des valeurs numériques caractéristiques de topologie (Attributs de topologie, comme défini plus haut), ce qui permet de les organiser et les enregistrer dans la base de données 141 sous ce format numérique. Chaque objet 3D y est ainsi associé à son numéro de pièce (partie des Attributs), ses Relations arborescentes, et ses Attributs de topologie, information stockée respectivement dans les bases de données 131, 121, 111.

Des premières relations logiques 210-211 et 212 entre respectivement les objets 3D 201/202 et 201/203 sont représentées. Ces relations logiques sont en lien avec les données de PBS, par la création du graphe de connaissance à partir de la structure de produit effectuée par le Générateur de graphe de connaissances 120. Au travers de ces relations logiques, il existe une relation de position et orientation géométrique entre les objets 3D, qui est définie et capitalisée pour lier ces objets 3D entre eux, sur un premier niveau relationnel.
Par exemple, l'objet 3D 201 représente une fixation, positionnée (relations matricielles et d'orientation) à deux positions géométriques relativement à l'objet 3D 202 (relations logiques 210-211), et une seule position géométrique relativement à l'objet 3D 203 (relation logique 212).

D'autres premières relations logiques 213 et 214 entre un sous-ensemble 204 du produit industriel, et respectivement l'objet 3D 202 et l'objet 3D 203, sont représentées. Ces Relations logiques sont également en lien avec les données de PBS, par la création du graphe de connaissance à partir de la structure de produit effectuée par le Générateur de graphe de connaissances 120. Plusieurs objets 3D sont ainsi regroupés en sous-ensemble 204, puis de proche en proche en un sous-ensemble 205, un sous-ensemble 206, jusqu'au produit industriel complet. Les modèles 3D sont ainsi organisés en groupes correspondant à un découpage du produit industriel en sous-ensembles, suivant en cela la structure de produit industriel.

De secondes relations logiques 220, 221, 222 entre respectivement les objets 3D 201/202, 201/203 et 202/203 sont représentées. Ces relations logiques sont en lien avec les données de PLM et de PBS : il s'agit d'un second niveau relationnel entre les objets 3D, qui, au-delà de la relation parent/enfant, met en oeuvre les Attributs et Règles. Par exemple:
- dans le cadre d'un assemblage de deux objets 3D, il peut y avoir une Règle de contrainte de « couple galvanique » entre les pièces correspondantes. En construisant la relation logique de second niveau relationnel, on s'assure que l'Attribut « Matériau » caractérise bien l'objet 3D, cet Attribut permettant de vérifier la compatibilité des matériaux dans le couple galvanique;
- en reprenant l'exemple ci-dessus d'une fixation (objet 3D 201) participant à l'assemblage de deux pièces (objets 3D 202 et 203) : les relations logiques 220 et 221 définissent le type de perçage dans chacune des deux pièces compatible avec la fixation, en fonction d'Attributs (ex : diamètre, longueur, type de fixation, etc.), et suivant des Règles (ex : règles de dessin et perçage propres à l'entreprise), information stockée dans la base de données 131.

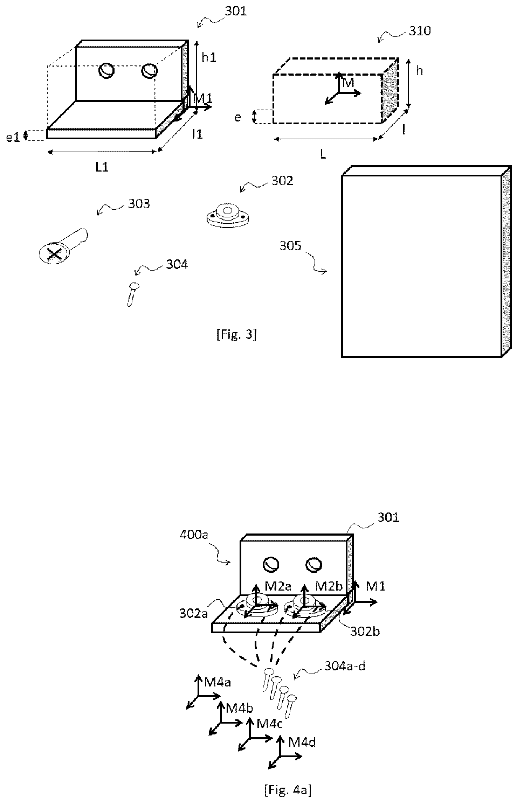

Les Fig.3 à Fig.5 illustrent un exemple simplifié de mise en oeuvre de l'invention. Fig.3 présente des pièces élémentaires d'un assemblage faisant partie d'un produit industriel :
- une Cornière 301 percée de deux trous;
- un Ecrou flottant 302 percé de deux trous;
- un Boulon 303;
- un Rivet 304; et
- un Cadre de structure 305.
Une Boîte d'encombrement générique (« Boundary Box », BBOX, en Anglais) est présentée sous la référence 310 : une telle boîte d'encombrement générique a vocation à caractériser, au travers de la Maquette numérique, chaque objet 3D pour chacune des pièces élémentaires 301-303, et 305. Une telle caractérisation s'effectue par exemple à l'aide d'une matrice d'orientation M par rapport à un référentiel (par exemple un repère constitué par une matrice M-Ref pour le produit industriel), de l'objet 3D contenu dans la boîte d'encombrement, et de paramètres Xmin/Xmax, Ymin/Ymax, et Zmin/Zmax, ce qui définit hauteur (h), largeur (l), et longueur (L) de l'objet 3D. Un autre paramètre peut être une épaisseur (e) comme dans le cas d'une tôle pliée formant une cornière.
Tous ces paramètres sont générés dans le Générateur topologique 3D et analyseur de similitudes 3D 110 de la Fig.1.
La Boîte d'encombrement générique 310 appliquée à la pièce élémentaire 301 par exemple, caractérise l'objet 3D correspondant au travers de sa hauteur h1, largeur l1, longueur L1, d'épaisseur e1, ainsi que d'une matrice d'orientation M1.

Fig.4a représente un premier sous-ensemble (« Part Assembly » en Anglais) de pièces élémentaires. Il met en oeuvre :
- la Cornière 301;
- deux Ecrous flottants 302a et 302b; et
- quatre Rivets 304a-d.
Certaines de ces pièces élémentaires sont des objets 3D, d'autres non.
Chaque objet 3D ayant été dessiné et positionné dans l'espace digital, les objets 3D ont des relations matricielles entre eux, qui sont définies lors de l'activité de dessin avec un logiciel de CAO, font partie des données de PLM, et qui sont enregistrées dans des tables et bases de données 131 de PLM.
Les Rivets 304a-d représentent un exemple de pièces élémentaires qui ne sont pas des objets 3D. Ils font parties des données de PLM comme pièces élémentaires par exemple au sein d'une nomenclature (« Bill of Material », BOM, en Anglais), mais ne sont pas présents dans une Maquette numérique. Ils font partie des données de PLM, avec leurs Attributs, leurs Règles et leurs Attributs de topologie associés. Ils ont ainsi en particulier une matrice d'orientation associée.
Ainsi :
M1 est la matrice d'orientation de la Cornière 301;
M2a (resp: M2b) est la matrice d'orientation de l'Ecrou flottant 302a (resp: 302b); et
M4a-d sont les matrices d'orientation de respectivement les Rivets 304a-d.

Le premier sous-ensemble est formé par :
- le perçage de la Cornière 301 à quatre emplacements fonction de l'écartement de quatre trous sur les Ecrous flottants 302a et 302b; et
- le positionnement des Ecrous flottants 302a et 302b, et leur assemblage à la Cornière 301 à l'aide des quatre Rivets 304a-d.

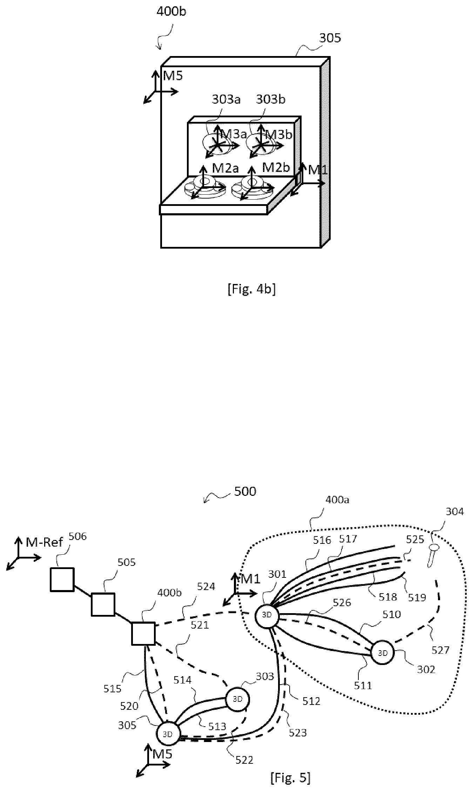

Fig.4b représente un second sous-ensemble de pièces élémentaires, ou solution de dessin. Elle met en oeuvre en plus du premier sous-ensemble:
- deux Boulons 303a et 303b; et
- le Cadre de structure 305.
M3a (resp: M3b) est la matrice d'orientation de l'Ecrou flottant 303a (resp: 303b).
M5 est la matrice d'orientation du Cadre de structure 305.

Le second sous-ensemble ou solution de dessin est formé par :
- le perçage du Cadre de structure 305 à deux emplacements fonction de l'écartement de deux trous sur la Cornière 301; et
- le positionnement de la Cornière 301, et son assemblage au Cadre de structure 305 à l'aide des deux Boulons 303a et 303b.

En Fig.5 est fournie une représentation simplifiée du graphe de connaissances généré par le Générateur de graphe de connaissances et de relations 120, dans le cas particulier des pièces élémentaires et sous-ensembles montrés aux Fig.3, Fig.4a et Fig.4b.
Tous les objets 3D 301-303 et 305 sont définis par les outils de CAO, et, grâce au Générateur topologique 3D et analyseur de similitudes 3D 110, sont caractérisés par des valeurs numériques caractéristiques de topologie (Attributs de topologie, comme défini plus haut), ce qui permet de les organiser et les enregistrer dans la base de données 141 sous ce format numérique. Chaque objet 3D y est ainsi associé à son numéro de pièce (partie des Attributs), ses Relations arborescentes, et ses Attributs de topologie, information stockée respectivement dans les bases de données 131, 121, 111.
Les Rivets 304a-d ne sont pas représentés comme des objets 3D mais comme des pièces élémentaires non-objets 3D.

Des premières relations logiques sont établies :
- 516-519, entre chacune de quatre instanciations du Rivet 304, correspondant aux quatre Rivets 304a-d de la Fig.4a, et la Cornière 301;
- 510-511, entre respectivement deux instanciations de l'Ecrou flottant 302, correspondant aux deux Ecrous flottants 302a-b de la Fig.4a, et la Cornière 301;
- 512, entre la Cornière 301 et le Cadre de structure 305;
- 513-514, entre respectivement deux instanciations du Boulon 303, correspondant aux deux Boulons 303a-b de la Fig.4b, et le Cadre de structure 305; et
- 515, entre le Cadre de structure 305, et le sous-ensemble ou solution de dessin 400b.

Toutes ces premières relations logiques 51x sont en lien avec les données de PBS, par la création du graphe de connaissance à partir de la structure de produit effectuée par le Générateur de graphe de connaissances 120. Au travers de ces relations logiques, il existe une relation de position et orientation géométrique entre les pièces élémentaires, qui est définie et capitalisée pour les lier entre elles, sur un premier niveau relationnel.

Ainsi notamment, au travers de ces relations logiques 51x, les relations entre matrices d'orientation sont établies:
- pour le sous-ensemble 400a : M2a-b/M1 et M4a-d/M1; et
- pour le sous-ensemble ou solution de dessin 400b : M1/M5, et M3a-b/M5.

Des secondes relations logiques sont établies :
- 520, 521, 524 entre respectivement les objets 3D Cadre de structure 305, Boulon 303, et Cornière 301, et le sous-ensemble ou solution de dessin 400b;
- 522, entre l'objet 3D Cadre de structure 305, et le Boulon 303;
- 523, entre l'objet 3D Cadre de structure 305, et la Cornière 301;
- 525, 527 entre le Rivet 304, et respectivement la Cornière 301 et l'Ecrou flottant 302; et
- 526, entre l'Ecrou flottant 302 et la Cornière 301.

Toutes ces secondes relations logiques 52x sont en lien avec les données de PLM et de PBS : il s'agit d'un second niveau relationnel entre les pièces élémentaires, qui, au-delà de la relation parent/enfant, met en oeuvre les Attributs et Règles.

Plusieurs pièces élémentaires sont ainsi regroupées en sous-ensemble 400a et 400b comme vu aux Fig.4a et Fig.4b, puis de proche en proche en un sous-ensemble 505, un sous-ensemble 506, jusqu'au produit industriel complet. Les pièces élémentaires sont ainsi organisées en groupes correspondant à un découpage du produit industriel en sous-ensembles, suivant en cela la structure de produit industriel. Au travers d'autres relations logiques (non numérotées) entre le sous-ensemble ou solution de dessin 400b, le sous-ensemble 505, et le sous-ensemble 506, les relations entre matrices d'orientation sont établies:
- M5/M-Ref.

Ainsi dans l'exemple de la Fig.5 :
- la relation logique 522 peut comporter une Règle de liaison entre chaque instanciation de Boulon 303, et le Cadre de structure 305, comportant par exemple le diamètre de perçage des deux trous du Cadre de structure 305, ou la force requise de serrage entre les deux;
- la relation logique 523 peut comporter une Règle de liaison entre la Cornière 301 et le Cadre de structure 305, par exemple des côtés de chacun qui doivent se faire face;
- la relation logique 525 peut comporter des Attributs, par exemple des listes de références d'éléments standard du marché du type de Rivet 304.
Chaque entreprise peut choisir quels Attributs et quelles Règles elle souhaite mettre en relation, pour une bonne gestion de son produit industriel.

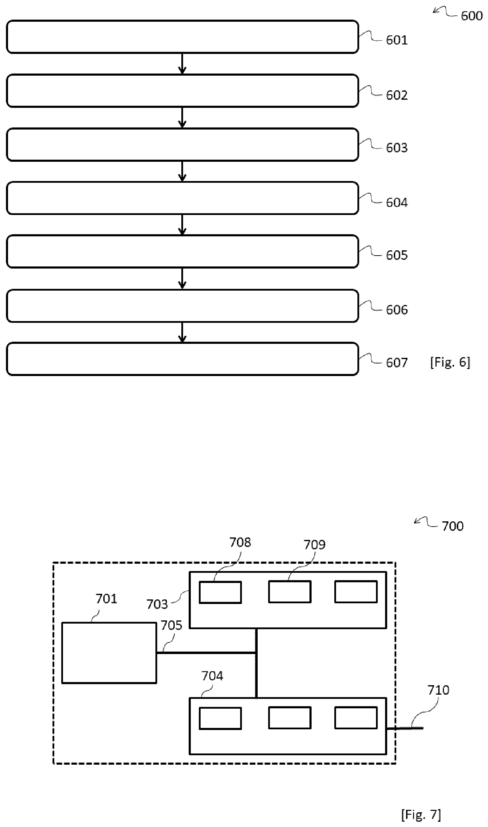

La Fig.6 fournit une représentation schématique des étapes du procédé 600 implémenté par exemple par ordinateur selon l'invention.
A l'étape 601, le procédé comprend d'acquérir des données de PLM de produit industriel comportant au moins deux pièces élémentaires, dont l'une au moins est un objet 3D généré par une Maquette numérique 3D.
A l'étape 602, le procédé comprend d'extraire des données de PLM des Attributs et Règles pour chaque pièce élémentaire.
A l'étape 603, le procédé comprend de générer un graphe de connaissances de Relations arborescentes établissant des relations logiques entre les pièces élémentaires sur le plan géométrique et fonctionnel.
A l'étape 604, le procédé comprend de générer des Attributs de topologie pour chaque pièce élémentaire.
A l'étape 605, le procédé comprend de regrouper pour chaque pièce élémentaire, ses Attributs et Règles, ses Relations arborescentes et ses Attributs de topologie dans au moins une base de données relationnelle, sous forme de voxel.
A l'étape 606, le procédé comprend de recevoir une requête d'un Utilisateur (102) relative à une solution technique, la requête comprenant au moins un volume 3D.
A l'étape 607, le procédé comprend d'évaluer si la solution technique est présente dans le PLM, et si elle n'est pas présente: de générer et fournir en réponse à la requête de l'Utilisateur (102), une solution technique nouvelle dans le volume 3D, mettant en oeuvre au moins un nouvel objet 3D, générer un nouveau voxel associé au nouvel objet 3D; et réinjecter le nouveau voxel dans la base de données relationnelle.

La Fig.7 illustre un système informatique qui peut être utilisé, par exemple pour réaliser le ou les calculateurs mis en oeuvre dans l'Extracteur d'Attributs et Règles 130, le Générateur de graphe de connaissances et de relations 120, le Générateur topologique 3D et analyseur de similitudes 3D 110, le Système d'apprentissage machine 3D 140, et/ou le Générateur de voxels et objets 3D 150, et/ou les étapes de procédé conformément à la Fig.6. Comme le comprendra l'homme du métier, un tel système informatique peut être implémenté dans tout autre matériel, logiciel et/ou micrologiciel approprié, ou une combinaison de ceux-ci, et peut être une entité physique unique, ou plusieurs entités physiques séparées avec une fonctionnalité distribuée.

Le système informatique 700 peut comprendre divers composants matériels, y compris un ou plusieurs processeurs simples ou multicœurs représentés collectivement par un processeur 701, une mémoire 703 et une interface d'entrée/sortie 704. Dans ce contexte, le processeur 701 peut ou non être inclus dans un FPGA. Le système informatique 700 peut être un système informatique générique "prêt à l'emploi". Le système informatique 700 peut également être réparti entre plusieurs systèmes. Le système informatique 700 peut également être spécifiquement dédié à la mise en œuvre de la présente invention. Comme l'homme du métier de la présente invention peut le comprendre, de multiples variantes quant à la façon dont le système informatique 700 est mis en œuvre peuvent être envisagées.
La communication entre les différents composants du système informatique 700 peut être activée par un ou plusieurs bus internes et/ou externes 705 (par exemple un bus PCI, un bus série universel, un bus IEEE 1394 "Firewire", un bus SCSI, un bus Serial-ATA bus, bus ARINC, etc.), auquel les différents composants matériels sont couplés électroniquement.

L'interface d'entrée/sortie 704 peut permettre des capacités de mise en réseau telles qu'un accès filaire ou sans fil. À titre d'exemple, l'interface d'entrée/sortie 704 peut comprendre une interface réseau telle que, mais sans s'y limiter, un port réseau, une prise réseau, un contrôleur d'interface réseau et similaire. De multiples exemples de la façon dont l'interface de mise en réseau peut être mise en œuvre deviendront apparents à l'homme du métier de la présente invention.

La mémoire 703 peut stocker des instructions de code 708, telles que celles faisant partie, par exemple, d'une bibliothèque, d'une application, etc. pouvant être chargées dans la mémoire 703 et exécutées par le processeur 701 pour, par exemple, mettre en oeuvre les étapes du procédé selon la présente invention. La mémoire 703 peut également stocker une base de données 709. L'homme du métier comprendra que la base de données 709, les instructions de code 708 et généralement la mémoire 703 peuvent également résider physiquement à l'extérieur du système informatique 700, toujours dans le cadre de la présente invention.

L'interface d'entrée/sortie 704 peut permettre au système informatique 700 d'être mis en communication avec d'autres processeurs via une connexion 710. Ce peut être le cas par exemple, si l'étape de calibration ci-dessus est mise en oeuvre dans le système informatique 700, alors que l'étape de corrélation ci-dessus est mise en oeuvre dans un processeur en dehors du système informatique 700, par exemple sur l'aéronef.

Bien que les mises en œuvre décrites ci-dessus aient été décrites et représentées en référence à des étapes particulières exécutées dans un ordre particulier, il sera entendu que ces étapes peuvent être combinées, subdivisées ou réordonnées sans s'écarter des enseignements de la présente divulgation. Au moins certaines des étapes peuvent être exécutées en parallèle ou en série. Par conséquent, l'ordre et le regroupement des étapes ne constituent pas une limitation de la présente invention.

Des modifications et des améliorations aux mises en œuvre décrites ci-dessus de la présente invention peuvent apparaître à l'homme du métier. La description ci-dessus est illustrative au travers d'exemples plutôt que limitative. La portée de la présente invention est donc limitée uniquement par la portée des revendications ci-dessous.

## Revendications

1. Procédé de génération de solution technique consistant en l'assemblage de pièces élémentaires, comprenant les étapes préalables de:
- acquérir (601) des données de PLM d'un produit industriel comportant au moins deux pièces élémentaires, dont l'une au moins est un objet 3D généré par une Maquette numérique 3D ;
- extraire (602) des données de PLM des Attributs et Règles pour chaque pièce élémentaire ;
- générer (603) un graphe de connaissances de Relations arborescentes basé sur les données de PLM et établissant des relations logiques entre les pièces élémentaires sur le plan géométrique et fonctionnel ;
- générer (604) des Attributs de topologie basés sur les données de PLM pour chaque pièce élémentaire ;
- regrouper (605) par un système d'apprentissage machine 3D pour chaque pièce élémentaire, les Attributs et Règles, les Relations arborescentes et les Attributs de topologie dans au moins une base de données relationnelle, sous forme de voxel ;
le procédé comprenant aussi les étapes de :
- recevoir (606) par le système d'apprentissage machine 3D une requête d'un Utilisateur (102) relative à la solution technique, la requête comprenant au moins un volume 3D et un Attribut de topologie caractérisant la ou les pièces élémentaires assemblées dans la solution technique;
- évaluer (607) par le système d'apprentissage machine 3D si la solution technique est présente dans le PLM, et si elle n'est pas présente :
- générer et fournir en réponse à la requête de l'Utilisateur (102), une solution technique nouvelle dans le volume 3D , mettant en oeuvre au moins un nouvel objet 3D ;
- générer un nouveau voxel associé au nouvel objet 3D ; et
- réinjecter le nouveau voxel dans la base de données relationnelle.

2. Le procédé de la revendication 1, dans lequel l'étape de regrouper comprend l'étape de sélectionner pour chaque pièce élémentaire certains des Attributs et Règles en fonction des Attributs de topologie.

3. Le procédé de la revendication 1 ou 2 comprenant en outre une étape de correction par l'Utilisateur dans le nouveau voxel, de tout ou partie des Attributs et Règles, Relations arborescentes, et Attributs de topologies, préalablement à l'étape de réinjecter le nouveau voxel dans la base de données relationnelle.

4. Le procédé de l'une quelconque des revendications 1 à 3, dans lequel le graphe de connaissances généré de Relations arborescentes entre les pièces élémentaires, comprend :
- des premières relations logiques (51x) entre les pièces élémentaires de position et d'orientation géométrique entre les pièces élémentaires ; et
- des secondes relations logiques (52x) entre les pièces élémentaires sur la base de tout ou partie des Attributs et Règles, choisie par l'Utilisateur.

5. Support lisible par ordinateur, comportant des instructions qui lorsqu'elles sont exécutées, conduisent l'ordinateur à réaliser le procédé des revendications 1 à 4.

6. Système de génération de solution technique consistant en l'assemblage de pièces élémentaires, comprenant :
- un Extracteur d'Attributs et Règles (130) configuré pour recevoir des données de PLM d'un produit industriel comportant au moins deux pièces élémentaires, et extraire, trier et organiser, des Attributs et Règles associés à chacune de pièces élémentaires composant le produit industriel ;
- un Générateur de graphe de connaissances et de relations (120) configuré pour transformer et structurer une décomposition arborescente d'un PBS du produit industriel faisant partie du PLM, en un graphe de connaissances de Relations arborescentes basé sur les données de PLM et établissant des relations logiques entre les pièces élémentaires sur le plan géométrique et fonctionnel;
- un Générateur topologique 3D et analyseur de similitudes 3D (110) configuré pour générer des Attributs de topologie basés sur les données de PLM et associés à chacune de pièces élémentaires ;
- un Système d'apprentissage machine 3D (140) et un Générateur de voxels et objets 3D (150) configurés pour :
- regrouper dans une ou plusieurs bases de données relationnelle sous forme de voxel par pièce élémentaire, le voxel comprenant les Attributs et Règles extraits, les Relations arborescentes transformées, et les Attributs de topologie générés ;
- recevoir (606) une requête d'un Utilisateur (102) relative à une solution technique, la requête comprenant au moins un volume 3D et un Attribut de topologie caractérisant la ou les pièces élémentaires assemblées dans la solution technique;
- évaluer (607) si la solution technique est présente dans le PLM, et si elle n'est pas présente :
- générer et fournir en réponse à la requête de l'Utilisateur (102), une solution technique nouvelle dans le volume 3D, mettant en oeuvre au moins un nouvel objet 3D ;
- générer un nouveau voxel associé au nouvel objet 3D ; et
- réinjecter le nouveau voxel dans la base de données relationnelle.

7. Le système de la revendication 6, dans lequel le Générateur de voxels et objets 3D (150) est en outre configuré pour recevoir une correction par l'Utilisateur dans le nouveau voxel, de tout ou partie des Attributs et Règles, Relations arborescentes, et Attributs de topologies, préalablement à l'étape de réinjecter le nouveau voxel dans la base de données relationnelle.

8. Le système de la revendication 6 ou 7, dans lequel le graphe de connaissances généré de Relations arborescentes entre les pièces élémentaires, comprend :
- des premières relations logiques (51x) entre les pièces élémentaires de position et d'orientation géométrique entre les pièces élémentaires ; et
- des secondes relations logiques (52x) entre les pièces élémentaires sur la base de tout ou partie des Attributs et Règles, choisie par l'Utilisateur.
